(19) Europäisches Patentamt
European Patent Office
Office européen des brevets

(11) **EP 3 435 103 B1**

(12) **FASCICULE DE BREVET EUROPEEN**

(45) Date de publication et mention
de la délivrance du brevet:
**16.10.2019 Bulletin 2019/42**

(51) Int Cl.:
***G01R 31/36*** *(2019.01)*     ***G01R 31/367*** *(2019.01)*
***G01R 31/382*** *(2019.01)*

(21) Numéro de dépôt: **18178171.7**

(22) Date de dépôt: **18.06.2018**

(54) **METHODE D'ESTIMATION D'UN ETAT D'ENERGIE D'UNE BATTERIE**

SCHÄTZUNGSMETHODE DES ENERGIEZUSTANDS EINER BATTERIE

METHOD FOR ESTIMATING THE ENERGY STATE OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.07.2017 FR 1757153**

(43) Date de publication de la demande:
**30.01.2019 Bulletin 2019/05**

(73) Titulaire: **Airbus (S.A.S.)**
**31700 Blagnac (FR)**

(72) Inventeurs:
• **FERRAN, Benoît**
**75011 PARIS (FR)**
• **DINEL, Clément**
**92130 ISSY-LES- MOULINEAUX (FR)**

(74) Mandataire: **Sarraméa, Claude**
**Airbus Operations (S.A.S)**
**XIF - M0101/1**
**316, route de Bayonne**
**31060 Toulouse Cedex (FR)**

(56) Documents cités:
**DE-A1-102015 114 652    US-A1- 2017 088 072**

• **DENG ZHONGWEI ET AL: "Maximum Available
Capacity and Energy Estimation Based on
Support Vector Machine Regression for
Lithium-ion Battery", ENERGY PROCEDIA,
ELSEVIER, NL, vol. 107, 9 mars 2017 (2017-03-09),
pages 68-75, XP029939371, ISSN: 1876-6102,
DOI: 10.1016/J.EGYPRO.2016.12.131**

**Description**

DOMAINE TECHNIQUE

L'invention appartient au domaine des batteries d'accumulateurs électriques.
Plus particulièrement, l'invention concerne une méthode d'estimation d'un état d'énergie d'une batterie.

ETAT DE L'ART

Il est répandu que les batteries des véhicules électriques ou hybrides HEV (*Hybrid Electric Vehicles* en terminologie anglo-saxonne) comportent un système de gestion implémentant un estimateur de l'état de charge SOC de la batterie. Le système de gestion fournit à un opérateur ou à un pilote du véhicule une estimation d'une charge électrique restante sur la capacité de la batterie, par exemple présentée sous la forme d'une autonomie de fonctionnement.
Toutefois, l'opérateur ou le pilote a davantage besoin d'une information concernant l'énergie disponible dans la batterie plutôt qu'une information concernant sa charge. Dans cette optique, l'état d'énergie SOE traduisant un pourcentage d'énergie restante dans la batterie. est une information pertinente.
Actuellement, il existe un nombre restreint d'estimateurs de l'état d'énergie SOE.
Un inconvénient de certains des estimateurs existant est qu'ils sont limités dans leur utilisation dans la mesure où ils ne sont valables que dans des cas restreints. Par exemple, certains estimateurs ne sont valables qu'en début de vie car ils ne prennent pas en compte dans leur estimation le vieillissement de la batterie.
Dans leur publication scientifique *A method for state of energy estimation of lithium-ion batteries based on neural network model,* G. Dong et al. décrivent une méthode visant à estimer l'état d'énergie de batteries de type lithium-ion sur la base d'un modèle de réseaux de neurones.
X. Liu et al. décrivent également, dans *A method for state of energy estimation of lithium-ion batteries at dynamic currents and temperatures,* un estimateur de l'état d'énergie de type réseau de neurones.
Un inconvénient de ces estimateurs est qu'ils sont complexes à mettre en oeuvre.
La demande internationale de brevet WO2016112960 décrit une méthode pour déterminer l'état d'énergie SOE par intégration de la courbe de tension aux bornes de la batterie sur un intervalle d'état de charge SOC donné.
La demande de brevet DE 10 2015 114652 A1, la demande de brevet US2017/088072A1, ainsi que la publication scientifique *Maximum Available Capacity and Energy Estimation Based on Support Vector Machine Regression for Lithium-ion Battery* de Zhongwei Deng et al., décrivent des méthodes pour déterminer l'état d'énergie SOE d'une batterie.

EXPOSE DE L'INVENTION

L'invention propose une alternative aux estimateurs d'état d'énergie existant. La mise en oeuvre de la solution de l'invention s'avère plus simple à mettre en oeuvre en comparaison avec les solutions de l'art antérieur mettant en oeuvre des réseaux de neurones.
L'invention concerne une méthode pour l'estimation d'un état d'énergie SOE d'une batterie, comportant une étape d'estimation d'un état de charge SOC de la batterie, ladite méthode étant caractérisée en ce qu'elle comporte en outre les étapes suivantes de :

- détermination préalable de l'évolution d'un écart $\Delta$ entre l'état de charge SOC et l'état d'énergie SOE en fonction dudit état de charge SOC ;
- détermination d'un écart $\Delta$ entre l'état de charge SOC et l'état d'énergie SOE en fonction d'une part dudit état de charge estimé à l'étape d'estimation et d'autre part de l'évolution de l'écart $\Delta$ déterminée lors de l'étape de détermination préalable ;
- calcul de l'état d'énergie SOE en fonction de l'état de charge SOC estimé à l'étape d'estimation et de l'écart $\Delta$ déterminé à l'étape de détermination.

Dans un mode de mise en oeuvre :

- l'étape de détermination préalable de l'évolution d'un écart $\Delta$ entre l'état de charge SOC et l'état d'énergie SOE en fonction dudit état de charge SOC correspond à la réalisation d'au moins un abaque représentant une évolution de l'écart $\Delta$ en fonction de l'état de charge de la batterie SOC ;
- l'écart $\Delta$ est déterminé, à l'étape de détermination, par le biais d'au moins un abaque réalisé au cours de ladite étape préalable.

Dans un mode de mise en oeuvre, au moins un abaque est réalisé expérimentalement.

Dans un mode de mise en oeuvre, au moins un abaque est réalisé par simulation.

Dans un mode de mise en oeuvre, l'écart Δ dépend d'au moins un des paramètres suivants de la batterie :

- une puissance aux bornes de ladite batterie ;
- un état de santé SOH (« State Of Health » en terminologie anglo-saxonne) ;
- une température de ladite batterie.

Dans un mode de mise en oeuvre, l'écart Δ déterminé est un écart maximal $\Delta_{op,max}$ déterminé sur une durée de vie de la batterie.

Dans un mode de mise en oeuvre, l'écart maximal $\Delta_{op,max}$ est déterminé dans des conditions d'utilisation de la batterie les plus défavorables.

Dans un mode de mise en oeuvre, la méthode comporte en outre une étape d'estimation de l'énergie disponible restant dans la batterie.

L'invention concerne également une batterie comportant un système de gestion de batterie BMS implémentant la méthode selon l'invention. Ledit système de gestion comporte :

- des moyens pour estimer l'état de charge SOC de la batterie ;
- des moyens pour déterminer l'écart Δ, et notamment au moins un abaque de l'évolution de l'écart Δ en fonction dudit état de charge ;
- des moyens pour calculer l'état d'énergie SOE de la batterie en fonction de l'état de charge SOC estimé et de l'écart Δ déterminé.

Dans une forme de réalisation, les moyens pour estimer l'état de charge SOC comportent un dispositif parmi :

- des moyens de mesure de tension ou d'impédance ;
- un estimateur de type compteur de Coulomb ;
- un système adaptatif mettant en oeuvre un filtre de Kalman ou des réseaux de neurones.

BREVE DESCRIPTION DES FIGURES

L'invention sera mieux comprise à la lecture de la description qui suit et à l'examen des figures qui l'accompagnent. Celles-ci ne sont présentées qu'à titre indicatif et nullement limitatif de l'invention.

La figure 1 représente les étapes principales de la méthode selon l'invention.
La figure 2 représente un modèle électrique d'une batterie.
La figure 3 représente une évolution, pour une batterie donnée, de l'écart entre l'état de charge et l'état d'énergie en fonction de l'état de charge, de la puissance de décharge aux bornes de la batterie, et du mode de détermination par l'expérimentation ou par simulation.
La figure 4 représente les évolutions temporelles de l'état de charge et de l'état d'énergie pour la batterie de la figure 3, pour une puissance donnée.
La Figure 5 représente de manière schématique une batterie selon l'invention.

DESCRIPTION DETAILLEE

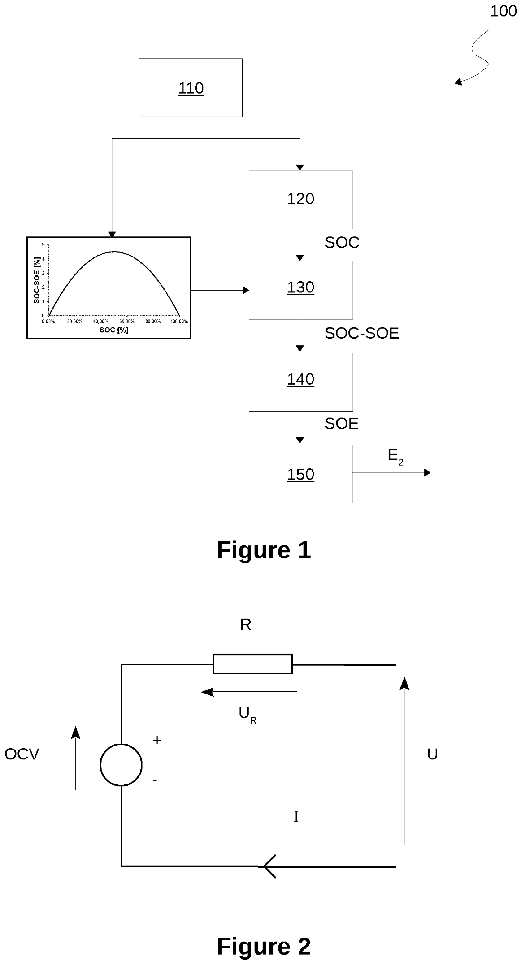

En référence à la figure 1, l'invention concerne une méthode 100 pour l'estimation d'un état d'énergie SOE (*State Of Energy* en terminologie anglo-saxonne) d'une batterie.

L'état d'énergie SOE, qui sera exprimé en pourcentage, correspond au rapport d'une énergie disponible dans la batterie à un instant t donné sur une énergie maximale que ladite batterie est en mesure de stocker à cet instant t.

La méthode selon l'invention comporte les étapes suivantes :

- estimation 120 d'un état de charge SOC (*State Of Charge* en terminologie anglo-saxonne) de la batterie ;
- détermination 130 d'un écart Δ quantifiant une différence entre l'état de charge SOC et l'état d'énergie SOE, pour l'état de charge de la batterie estimé à l'étape précédente ;
- calcul 140 de l'état d'énergie SOE.

L'état de charge SOC, exprimé en pourcentage, est le rapport d'une charge électrique disponible dans la batterie à un instant t sur une capacité de la batterie à cet instant, c'est-à-dire la charge électrique maximale qu'elle est susceptible de stocker compte-tenu par exemple de son état de vieillissement.

L'état de charge SOC et l'état d'énergie SOE sont des grandeurs qui dépendent notamment des paramètres suivants :

- une puissance P fournie à la batterie (cas de la charge) ou délivrée par ladite batterie (cas de la décharge) ;
- un état de santé SOH (*State Of Health* en terminologie anglo-saxonne) de la batterie, tenant compte des vieillissements calendaire et en cyclage ;
- une température T de la batterie.

L'état de charge SOC et l'état d'énergie SOE s'expriment formellement de la manière suivante :

$$SOC(t_f) = SOC(t_i) + \frac{1}{C(SOH;T;P)} \int_{t_i}^{tf} I(t)dt \qquad (1)$$

$$SOE(t_f) = SOE(t_i) + \frac{1}{E(SOH;T;P)} \int_{t_i}^{tf} U(t)I(t)dt \qquad (2)$$

avec :

- $t_i$ : instant de début de charge (ou de décharge) ;
- $t_f$ : instant de fin de charge (ou de décharge) ;
- $I(t)$ : intensité fournie à ou délivrée par la batterie ;
- $U(t)$ : tension aux bornes de la batterie ;
- C : capacité de la batterie ;
- E : énergie maximale de la batterie.

L'estimation 110 de l'état de charge SOC peut être réalisée par tout moyen connu, notamment :

- mesure directe (méthode de la tension en circuit ouvert, méthode de la tension terminale, méthode par impédance,...) ;
- estimateurs ;
- systèmes adaptatifs.

Par exemple, un compteur de Coulomb peut être mis en place. Selon la méthode du compteur de Coulomb, l'état de charge SOC est estimé à l'instant n$\Delta$t à partir d'un instant (n-1)$\Delta$t précédent selon la formule :

$$SOC(n) = SOC(n-1) + \frac{i(t)\Delta t}{K}$$

Où K est une constante.
Le brevet britannique GB 2490295 décrit une méthode de gestion de la charge d'une batterie utilisant un compteur de Coulomb.
Un système adaptatif de type réseaux de neurones ou filtre de Kalman peut également être mis en place. Le brevet français FR 2853081 décrit un système de détermination d'un état de charge instantané d'une batterie implémentant un filtre de Kalman.
L'état de charge SOC estimé lors de cette étape est noté dans la suite $SOC_{op}$.
Une fois l'état de charge $SOC_{op}$ estimé, par exemple par un des moyens décrits ci-dessus, l'écart $\Delta$, pour cet état de charge $SOC_{op}$, est déterminé 130.
L'écart $\Delta$ est défini de manière générale par la relation :

$$\Delta = SOC - SOE$$

Dans un mode de mise en oeuvre de l'invention, l'évolution de l'écart Δ en fonction de l'état de charge SOC est déduite d'abaques réalisés de manière expérimentale.

La réalisation expérimentale des abaques se fait de la manière suivante : on réalise des essais sur une cellule de décharge à puissance constante, à différents états de santé SOH, différentes températures cellules et différentes puissances de décharge. Les paramètres enregistrées sont a minima : courant, tension, puissance, capacité, énergie, température. Lorsque l'essai est fini on calcule la capacité maximale déchargée et on a ainsi l'évolution de l'état de charge SOC au cours de la décharge (capacité déchargée à tout instant / capacité maximale). De même on calcule l'énergie maximale déchargée et on a ainsi l'évolution de l'état d'énergie SOE au cours de la décharge (énergie déchargée à tout instant / énergie maximale).

On peut alors tracer différents abaques de Δ pour différents SOH, températures cellules, puissance de décharge.

Dans un mode de mise en oeuvre alternatif, l'écart Δ est simulé numériquement. En référence à la figure 2, la batterie peut être modélisée par une source de tension en circuit ouvert OCV (*Open Circuit Voltage* en terminologie anglo-saxonne) connectée à une résistance interne R placée en série (modèle de Rint). La résistance interne, associée aux pertes par effet Joule, augmente au cours de la durée de vie de la batterie. Selon ce modèle, et suivant les conventions retenues sur la figure 2, la tension U aux bornes de la batterie est égale à :

$$U(t) = OCV(t) - RI(t)$$

L'état d'énergie SOE peut être réécrit, à partir de l'équation (2) :

$$SOE(t_f) = SOE(t_i) + \frac{1}{E(SOH;T;P)}\left(\int_{t_i}^{tf} OCV(t)I(t)dt - \int_{t_i}^{tf} R(t)I^2(t)dt\right) \quad (3)$$

Cette équation (3) fait apparaître qu'un écart entre l'état de charge SOC et l'état d'énergie SOE est imputable à :

- la tension en circuit ouvert OCV ;
- la puissance dissipée par effet Joule du fait de la résistance interne R.

Dans cette forme de mise en oeuvre, l'écart Δ entre l'état de charge SOC et l'état d'énergie SOE est simulé sur la base de cette équation, en s'appuyant par exemple sur des cartographies de la tension en circuit ouvert OCV et R en fonction de la température de la batterie et de l'état de santé SOH.

Avantageusement, un ou plusieurs abaques simulés numériquement peuvent être utilisés en complément d'un ou plusieurs abaques expérimentaux pour consolider les résultats expérimentaux.

De manière générale, il convient de noter que l'écart Δ dépend de :

- une puissance aux bornes de la batterie ;
- l'état de santé SOH de la batterie ;
- la température de la batterie.

Dans tous les cas, les abaques sont réalisés préalablement, lors d'une étape de réalisation 110 d'au moins un abaque à la mise en oeuvre de l'invention.

Dans un mode de mise en oeuvre, le courant aux bornes de la batterie est pris en compte dans la réalisation des abaques. Ce mode de mise en oeuvre est particulièrement adapté à une implémentation de la méthode dans des systèmes hybrides, au sein desquels la batterie est amenée à subir des variations importantes de courant à ses bornes.

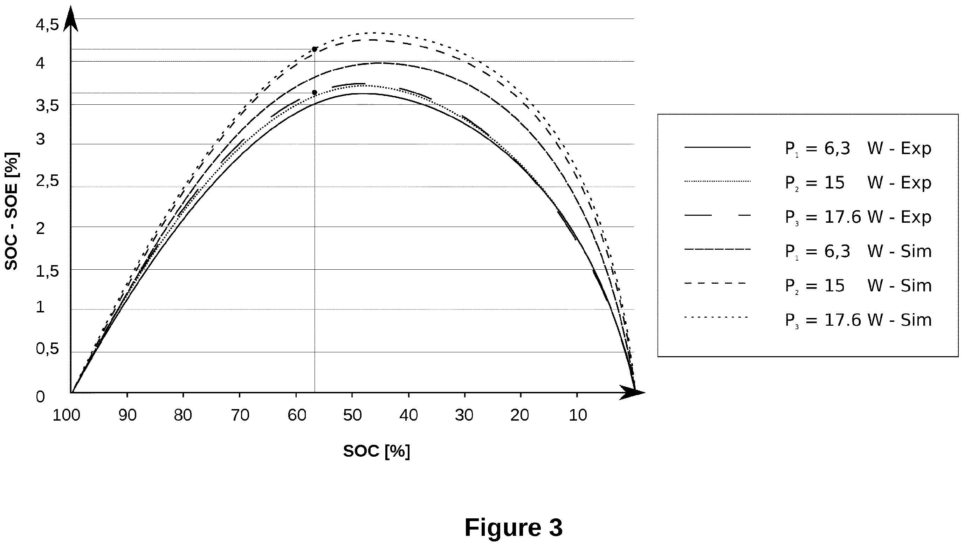

La figure 3 illustre un exemple d'abaques donnant l'écart Δ en fonction de l'état de charge SOC. Ces abaques ont été réalisés dans les conditions suivantes :

- phase de décharge de la batterie, pour trois puissances de décharge différentes :

  - $P_1$ = 6.3 W ;
  - $P_1$ = 15 W ;
  - $P_1$ = 17.6 W ;

- en début de vie de la batterie (SOH ≥ 98%) ;

- température de batterie T de 23°C ;

Les puissances de décharge d'intérêt $P_1$, $P_2$ et $P_3$ correspondent à des ordres de grandeur typiquement rencontrés dans le domaine de l'aéronautique, pour des phases de palier, montée continue et montée initiale respectivement.

Les abaques sont réalisés de manière expérimentale d'une part et par simulation d'autre part. Le nom des courbes réalisées expérimentalement apparaît dans la légende de la figure 3 avec le suffixe « - Exp ». Le nom des courbes réalisées par simulation apparaît dans la légende de cette figure avec le suffixe « - Sim ».

Il apparaît que l'écart $\Delta$ obtenu augmente avec la puissance de décharge. De manière générale, l'écart $\Delta$ augmente avec :

- la puissance de charge ou de décharge aux bornes de la batterie ;
- la résistance interne dissipant la puissance par effet Joule, laquelle résistance interne, augmente avec :

  • l'âge de la batterie ;
  • une diminution de la température de batterie.

La détermination 130 de l'écart $\Delta$ se fait par le biais des abaques réalisés de manière expérimentale ou par simulation. On note $\Delta_{op}$ l'écart relevé correspondant à l'état de charge $SOC_{op}$.

Par la suite, l'état d'énergie SOE est calculé 140. L'état d'énergie $SOE_{op}$ correspondant à l'état de charge $SOC_{op}$ est calculé suivant la relation suivante :

$$SOE_{op} = SOC_{op} - \Delta_{op}$$

En référence à la figure 3, pour un état de charge $SOC_{op}$ de 57% et une puissance de décharge de 17.6 W, l'écart $\Delta_{op,exp}$ maximal, basé sur les résultats expérimentaux, est égal à 4.15%. L'état d'énergie $SOE_{op,exp}$ associé est égal à :

$$SOE_{op,exp} = SOC_{op} - \Delta_{op,exp} = 52.85\%$$

De même, pour un état de charge $SOC_{op}$ de 57% et une puissance de décharge de 17.6W, l'écart $\Delta_{op,sim}$ maximal, basé sur les résultats de simulation, est égal à 3.65%. L'état d'énergie $SOE_{op,sim}$ associé est égal à :

$$SOE_{op,exp} = SOC_{op} - \Delta_{op,exp} = 53.35\%$$

Les abaques de la figure 3 sont valables pour un état de santé SOH donné de la batterie. Afin de prévenir une surestimation excessive de l'état d'énergie SOE, il est fait l'hypothèse, dans un mode de mise en oeuvre de la méthode selon l'invention, d'un écart $\Delta_{op,max}$ indépendant de l'état de santé SOH, pour un état de charge $SOC_{op}$ donné, et égal au maximum des écarts observés à cet état de charge sur toute la durée de vie de la batterie. Dans un mode alternatif de mise en oeuvre, cet écart est également pris indépendant de la puissance aux bornes de la batterie et de sa température. L'écart est alors déterminé dans les conditions les plus défavorables.

A titre d'exemple, si un abaque indique que l'écart $\Delta_{op}$ maximal est de 4.5%, quelles que soient l'âge de la batterie, la puissance à ses bornes et sa température, et sous l'hypothèse d'un état de charge $SOC_{op}$ de 57%, l'état d'énergie $SOE_{op}$ est égal à 52.5% sur toute la durée de vie de la batterie pour cet état de charge.

En référence à la figure 3, il convient de noter que l'écart $\Delta$ est proche de zéro en début de décharge et en fin de décharge de la batterie, et maximal pour un état de charge SOC d'environ 45%.

Par la suite, il est possible d'estimer 150 l'énergie disponible dans la batterie.

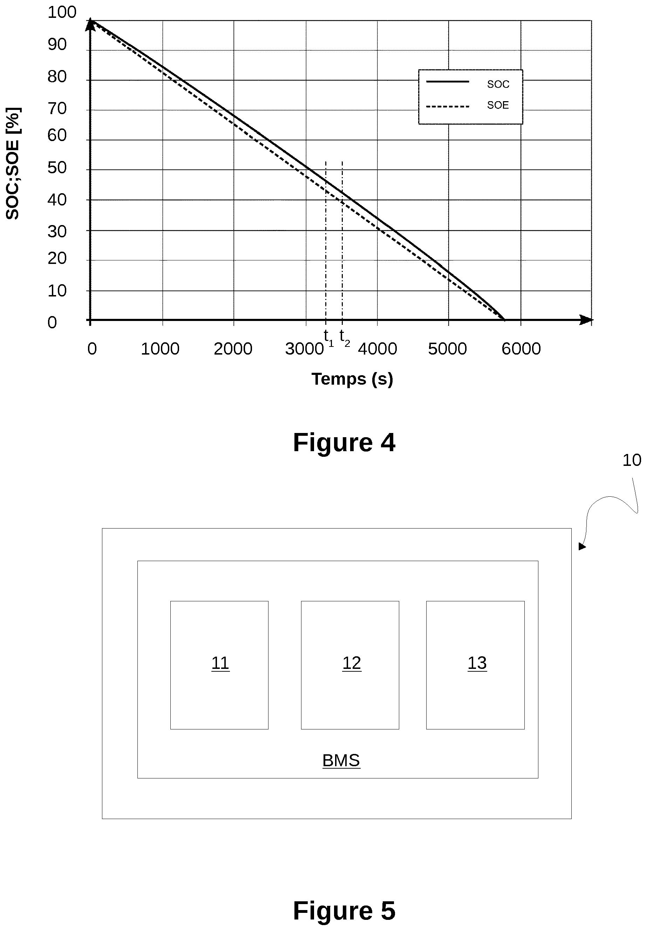

La figure 4 illustre les profils d'état de charge $SOC_{op}$ et d'état d'énergie $SOE_{op}$ estimés, en fonction du temps, pour une puissance aux bornes de la batterie égale à $P_1$, soit 6.3W, lors d'une phase de décharge.

On considère un intervalle temporel $[t_1;t_2]$ sur lequel l'état d'énergie SOE a été estimé, de la manière décrite plus haut, par exemple :

$$t_1 = 3392\ s$$

$$t_2 = 3422\,s$$

La puissance délivrée par la batterie est considérée comme constante sur cet intervalle temporel. En conséquence, l'état d'énergie SOE décroît de manière linéaire sur ledit intervalle temporel.

Par extrapolation linéaire, il est possible d'estimer l'instant $t_d$ auquel l'état d'énergie SOE sera nul, ce qui correspond à une décharge totale de la batterie. Dans l'exemple de la figure 4, on obtient :

$$t_d = 5787s$$

On en déduit une estimation de l'énergie restante $E_2$ à l'instant $t_2$ dans la batterie :

$$E_2 = P_1(t_d - t_2)$$

Où $P_1$ est la puissance délivrée par la batterie et $t_d$-$t_2$ le temps restant estimé par extrapolation linéaire avant décharge totale de la batterie.

On en déduit, dans l'exemple de la figure 4 :

$$E_2 = 4.1\,Wh$$

Il convient de noter que, si l'exemple de mise en oeuvre des figures 3 et 4 illustre une phase de décharge d'une batterie, la méthode selon l'invention s'applique, *mutatis mutandis,* à une phase de charge de ladite batterie.

L'invention concerne également une batterie comportant un système de gestion de batterie BMS (*Battery Management System* en terminologie anglo-saxonne) implémentant la méthode selon l'invention.

Le système de gestion de batterie BMS selon l'invention comporte des moyens pour :

- estimer l'état de charge SOC de la batterie ;
- déterminer l'écart $\Delta$, et notamment des moyens pour utiliser et éventuellement mémoriser au moins un abaque de l'évolution de l'écart $\Delta$ en fonction dudit état de charge ;
- calculer l'état d'énergie SOE de la batterie.

Les moyens pour estimer l'état de charge SOC peuvent être par exemple :

- des moyens de mesure de tension ou d'impédance ;
- un estimateur de type compteur de Coulomb ;
- un système adaptatif mettant en oeuvre par exemple un filtre de Kalman ou des réseaux de neurones.

L'invention permet d'indiquer à un opérateur un niveau ou un pourcentage d'énergie estimés à disposition dans une batterie à un instant donné. L'invention est simple à mettre en oeuvre dans la mesure où :

- elle se base sur des estimateurs de l'état de charge SOC classiquement utilisés pour estimer l'état de charge SOC de la batterie ;
- le nombre d'essais expérimentaux est limité en comparaison des estimateurs d'état d'énergie existant ;
- il n'est pas nécessaire d'estimer la chute de tension aux bornes de la batterie, par exemple par estimation de l'impédance de la batterie, car sa connaissance n'est pas nécessaire à la mise en oeuvre de l'invention.

Par ailleurs, l'invention prend en compte le vieillissement de la batterie puisque l'écart $\Delta$ dépend de l'état de santé de la batterie.

## Revendications

1. Méthode (100) pour l'estimation d'un état d'énergie SOE d'une batterie, comportant une étape d'estimation (120) d'un état de charge SOC de la batterie, ladite méthode étant **caractérisée en ce qu'**elle comporte en outre les étapes suivantes de :

- détermination préalable (110) de l'évolution d'un écart $\Delta$ entre l'état de charge SOC et l'état d'énergie SOE en fonction dudit état de charge SOC ;
- détermination (130) d'un écart $\Delta$ entre l'état de charge SOC et l'état d'énergie SOE en fonction d'une part dudit état de charge estimé à l'étape d'estimation (120) et d'autre part l'évolution de l'écart $\Delta$ déterminée lors de l'étape de détermination préalable (110) ;
- calcul (140) de l'état d'énergie SOE en fonction de l'état de charge SOC estimé à l'étape d'estimation (120) et de l'écart $\Delta$ déterminé à l'étape de détermination (130).

2. Méthode (100) selon la revendication 1 **caractérisée en ce que** :

- l'étape de détermination préalable (110) de l'évolution d'un écart $\Delta$ entre l'état de charge SOC et l'état d'énergie SOE en fonction dudit état de charge SOC correspond à la réalisation d'au moins un abaque représentant une évolution de l'écart $\Delta$ en fonction de l'état de charge de la batterie SOC ;
- l'écart $\Delta$ est déterminé à l'étape (130) par le biais d'au moins un abaque réalisé au cours de ladite étape préalable (110).

3. Méthode (100) selon la revendication 2 **caractérisée en ce qu'**au moins un abaque est réalisé expérimentalement.

4. Méthode (100) selon la revendication 2 ou la revendication 3 **caractérisée en ce qu'**au moins un abaque est réalisé par simulation.

5. Méthode (100) selon l'une quelconque des revendications précédentes **caractérisée en ce que** l'écart $\Delta$ dépend d'au moins un des paramètres de la batterie parmi :

- une puissance aux bornes de ladite batterie ;
- un état de santé SOH (« State Of Health » en terminologie anglo-saxonne);
- une température de ladite batterie.

6. Méthode (100) selon la revendication 5 **caractérisée** en que l'écart $\Delta$ déterminé est un écart maximal $\Delta_{op,max}$ déterminé sur une durée de vie de la batterie.

7. Méthode (100) selon la revendication 6 **caractérisée en ce que** l'écart maximal $\Delta_{op,max}$ est déterminé dans des conditions d'utilisation de la batterie les plus défavorables.

8. Méthode (100) selon l'une quelconque des revendications précédentes **caractérisée en ce qu'**elle comporte en outre une étape d'estimation (150) de l'énergie disponible restant dans la batterie.

9. Batterie (10) comportant un système de gestion de batterie BMS implémentant la méthode selon l'une quelconque des revendications 1 à 8, **caractérisée en ce que** ledit système de gestion comporte :

- des moyens (11) pour estimer l'état de charge SOC de la batterie ;
- des moyens (12) pour déterminer l'écart $\Delta$, et notamment au moins un abaque de l'évolution de l'écart D en fonction dudit état de charge ;
- des moyens (13) pour calculer l'état d'énergie SOE de la batterie en fonction de l'état de charge SOC estimé et de l'écart $\Delta$ déterminé.

10. Batterie selon la revendication 9 **caractérisée en ce que** les moyens (11) pour estimer l'état de charge SOC comportent un dispositif parmi :

- des moyens de mesure de tension ou d'impédance ;
- un estimateur de type compteur de Coulomb ;
- un système adaptatif mettant en oeuvre un filtre de Kalman ou des réseaux de neurones.

**Patentansprüche**

1. Verfahren (100) zum Schätzen des Energiezustands SOE einer Batterie, umfassend einen Schritt des Schätzens (120) eines Ladezustands SOC der Batterie, wobei das Verfahren **dadurch gekennzeichnet ist, dass** es ferner die folgenden Schritte umfasst:

   - Vorabbestimmen (110) der Veränderung einer Differenz Δ zwischen dem Ladezustand SOC und dem Energiezustand SOE in Abhängigkeit von dem Ladezustand SOC;
   - Bestimmen (130) einer Differenz Δ zwischen dem Ladezustand SOC und dem Energiezustand SOE in Abhängigkeit von einerseits dem im Schritt des Schätzens (120) geschätzten Ladezustand und andererseits der beim Schritt des Vorabbestimmens (110) bestimmten Differenz Δ;
   - Berechnen (140) des Energiezustands SOE in Abhängigkeit von dem im Schritt des Schätzens (120) geschätzten Ladezustand soc und der im Schritt des Bestimmens (130) bestimmten Differenz Δ.

2. Verfahren (100) nach Anspruch 1, **dadurch gekennzeichnet, dass**:

   - der Schritt des Vorabbestimmens (110) der Veränderung einer Differenz Δ zwischen dem Ladezustand SOC und dem Energiezustand SOE in Abhängigkeit von dem Ladezustand SOC der Erstellung mindestens eines Diagramms entspricht, das eine Veränderung der Differenz Δ in Abhängigkeit vom Ladezustand der Batterie SOC darstellt;
   - die Differenz Δ im Schritt (130) über mindestens ein Diagramm bestimmt wird, das im Vorabschritt (110) erstellt wird.

3. Verfahren (100) nach Anspruch 2, **dadurch gekennzeichnet, dass** mindestens ein Diagramm experimentell erstellt wird.

4. Verfahren (100) nach Anspruch 2 oder Anspruch 3, **dadurch gekennzeichnet, dass** mindestens ein Diagramm durch Simulation erstellt wird.

5. Verfahren (100) nach einem der vorhergehenden Ansprüche, **dadurch gekennzeichnet, dass** die Differenz Δ von mindestens einem der folgenden Parameter der Batterie abhängig ist:

   - eine Leistung an den Klemmen der Batterie;
   - ein Gesundheitszustand SOH (im Englischen "State Of Health");
   - eine Temperatur der Batterie.

6. Verfahren (100) nach Anspruch 5, **dadurch gekennzeichnet, dass** die bestimmte Differenz Δ eine maximale Differenz $\Delta_{op,max}$ ist, die über eine Lebensdauer der Batterie bestimmt wird.

7. Verfahren (100) nach Anspruch 6, **dadurch gekennzeichnet, dass** die maximale Differenz $\Delta_{op,max}$ unter ungünstigsten Verwendungsbedingungen der Batterie bestimmt wird.

8. Verfahren (100) nach einem der vorhergehenden Ansprüche, **dadurch gekennzeichnet, dass** es ferner einen Schritt des Schätzens (150) der verfügbaren Energie umfasst, die noch in der Batterie ist.

9. Batterie (10) mit einem Batteriemanagementsystem BMS, welches das Verfahren nach einem der Ansprüche 1 bis 8 einsetzt, **dadurch gekennzeichnet, dass** das Managementsystem Folgendes umfasst:

   - Mittel (11) zum Schätzen des Ladezustands SOC der Batterie;
   - Mittel (12) zum Bestimmen der Differenz Δ und insbesondere mindestens eines Diagramms der Veränderung der Differenz Δ in Abhängigkeit von dem Ladezustand;
   - Mittel (13) zum Berechnen des Ladezustands SOE der Batterie in Abhängigkeit vom geschätzten Ladezustand SOC und von der bestimmten Differenz Δ.

10. Batterie nach Anspruch 9, **dadurch gekennzeichnet, dass** die Mittel (11) zum Schätzen des Ladezustands SOC eine der folgenden Vorrichtungen umfassen:

   - Mittel zur Spannungs- oder Impedanzmessung;

- einen Schätzer von der Art eines Coulomb-Zählers;
- ein adaptives System, das ein Kalman-Filter oder neuronale Netze einsetzt.

**Claims**

1. Method (100) for estimating a state of energy SOE of a battery, comprising a step of estimation (120) of a state of charge SOC of the battery, said method being **characterized in that** it also comprises the following steps of:

   - preliminary determination (110) of the trend of a discrepancy $\Delta$ between the state of charge SOC and the state of energy SOE as a function of said state of charge SOC;
   - determination (130) of a discrepancy $\Delta$ between the state of charge SOC and the state of energy SOE as a function on the one hand of said state of charge estimated in the estimation step (120) and on the other hand of the trend of the discrepancy $\Delta$ determined in the preliminary determination step (110);
   - computation (140) of the state of energy SOE as a function of the state of charge SOC estimated in the estimation step (120) and of the discrepancy $\Delta$ determined in the determination step (130) .

2. Method (100) according to Claim 1, **characterized in that**:

   - the step of preliminary determination (110) of the trend of a discrepancy $\Delta$ between the state of charge SOC and the state of energy SOE as a function of said state of charge SOC corresponds to the production of at least one chart representing a trend of the discrepancy $\Delta$ as a function of the state of charge SOC of the battery;
   - the discrepancy $\Delta$ is determined in the step (130) through at least one chart produced during said preliminary step (110).

3. Method (100) according to Claim 2, **characterized in that** at least one chart is produced experimentally.

4. Method (100) according to Claim 2 or Claim 3, **characterized in that** at least one chart is produced by simulation.

5. Method (100) according to any one of the preceding claims, **characterized in that** the discrepancy $\Delta$ depends on at least one of the parameters of the battery out of:

   - a power at the terminals of said battery;
   - a state of health SOH;
   - a temperature of said battery.

6. Method (100) according to Claim 5, **characterized in that** the determined discrepancy $\Delta$ is a maximum discrepancy $\Delta_{op,max}$ determined over a lifetime of the battery.

7. Method (100) according to Claim 6, **characterized in that** the maximum discrepancy $\Delta_{op,max}$ is determined in the worst case conditions of use of the battery.

8. Method (100) according to any one of the preceding claims, **characterized in that** it also comprises a step of estimation (150) of the available energy remaining in the battery.

9. Battery (10) comprising a battery management system BMS implementing the method according to any one of Claims 1 to 8, **characterized in that** said management system comprises:

   - means (11) for estimating the state of charge SOC of the battery;
   - means (12) for determining the discrepancy $\Delta$, and in particular at least one chart of the trend of the discrepancy $\Delta$ as a function of said state of charge;
   - means (13) for computing the state of energy SOE of the battery as a function of the estimated state of charge SOC and of the determined discrepancy $\Delta$.

10. Battery according to Claim 9, **characterized in that** the means (11) for estimating the state of charge SOC comprise a device out of:

    - means for measuring voltage or impedance;

- an estimator of Coulomb counter type;
- an adaptive system implementing a Kalman filter or neural networks.

100

110

120

SOC

130

SOC-SOE

140

SOE

150

E$_2$

**Figure 1**

R

U$_R$

OCV

+

-

U

I

**Figure 2**

**Figure 3**

**Figure 4**

**Figure 5**

**RÉFÉRENCES CITÉES DANS LA DESCRIPTION**

**Documents brevets cités dans la description**

- WO 2016112960 A
- DE 102015114652 A1
- US 2017088072 A1
- GB 2490295 A
- FR 2853081